# EUROPÄISCHE PATENTSCHRIFT

(11) **EP 1 182 779 B1**
(45) Veröffentlichungstag und Bekanntmachung des Hinweises auf die Patenterteilung: **13.02.2008**
(21) Anmeldenummer: 01117136.0
(22) Anmeldetag: 13.07.2001
(51) Int. Cl.: H03K 19/173, G11C 16/04

(54) **Verfahren und System zum Einstellen der elektrischen Eigenschaften mikroelektrischer Schaltungsanordnungen sowie Verwendung eines mikroelektronischen Schaltungselements**
Device and system for adjusting the electrical characteristics of microelectronic-circuits as well as the use of a microelectronical circuit element
Dispositif et système pour ajuster les caractéristiques électriques de circuits microélectroniques et l'utilisation d'un élement de circuit électronique

(30) Priorität: 26.07.2000 DE 10037447
(43) Veröffentlichungstag der Anmeldung: 27.02.2002
(73) Patentinhaber: Qimonda AG, 81739 München (DE)
(72) Erfinder: Bradl, Stephan, 93096 Koefering (DE); Gehring, Oliver, 01069 Dresden (DE); Heitzsch, Olaf, 01640 Coswig (DE)
(74) Vertreter: Graf Lambsdorff, Matthias

(56) Entgegenhaltungen:
- EP-A- 0 978 843
- US-A- 5 933 366
- US-A- 5 952 946
- US-A- 6 040 993
- PATENT ABSTRACTS OF JAPAN vol. 2000, no. 04, 31. August 2000 (2000-08-31) & JP 2000 021184 A (TEXAS INSTR INC <TI>;CONSORZIO EAGLE), 21. Januar 2000 (2000-01-21)

## Beschreibung

Die Erfindung betrifft ein Verfahren und ein System zum Einstellen der elektrischen Eigenschaften einer mikroelektronischen Schaltungsanordnung, wobei die Schaltungsanordnung zumindest eine analoge elektronische Einheit aufweist. Die Erfindung betrifft ferner die Verwendung eines mikroelektronischen Schaltungselements zum Einstellen der Eigenschaften einer derartigen Schaltungsanordnung.

Das Design mikroelektronischer Schaltungsanordnungen, insbesondere solcher Schaltungsanordnungen, die sowohl analoge elektronische Einheiten als auch digitale Einheiten aufweisen, ist eine der anspruchsvollen Aufgaben in der Elektrotechnik der Gegenwart. Obwohl üblicherweise vor der Herstellung der Schaltungsanordnungen Simulationen durchgeführt werden, kann ein fehlerfreies Design nicht garantiert werden. Die Folgen von fehlerhaften Designs sind unter anderem eine zeit- und kostenaufwendige Fehlersuche, die wiederholte Anfertigung teurer Masken für die Herstellung der mikroelektronischen Schaltungsanordnungen und das Re-Design der Schaltungsanordnung.

Bei mikroelektronischen Schaltungsanordnungen werden seit einiger Zeit programmierbare logische Schaltungsanordnungen (PLD) verwendet. Zu den PLD gehören unter anderem PLA (Programmable Logic Arrays), PAL (Programmable Array Logic) und FPGA (Field Programmable Gate Arrays). Gemein ist den PLD, daß digitale Einheiten zur Verarbeitung digitaler Information unterschiedlich verknüpft, d.h. programmiert werden können. Insbesondere FPGA ermöglichen auf diese Weise die vorherige hardwaremäßige Überprüfung von Designs digitaler Schaltungsanordnungen. FPGA bestehen aus einer großen Anzahl konfigurierbarer logischer Blöcke, sowie aus einem Netz von Leitungen, das nahezu jedes angeforderte Muster von Verbindungen zwischen den Blöcken bereitstellen kann. Dafür stehen an den Kreuzungspunkten der Leitungen Schalter zur Verfügung, die durch externe Signale betätigt werden.

Aus US 5,563,526 ist eine programmierbare Schaltungsanordnung mit sowohl digitalen als auch analogen Schaltungseinheiten bekannt. Neben den Möglichkeiten, die bereits FPGA bieten, können auch die analogen Eigenschaften der analogen Einheiten verändert werden und können die analogen Einheiten miteinander und/oder mit den digitalen Einheiten in unterschiedlicher Weise verknüpft werden.

Beispielsweise offenbart US 5,563,526 eine analoge Einheit, die sowohl als Komparator als auch als Operationsverstärker programmiert werden kann. Hierzu weist die analoge Einheit einen programmierbaren Schalter auf, der im geschlossenen Zustand den Betrieb als Operationsverstärker und im offenen Zustand den Betrieb als Komparator ermöglicht.

Wie auch bei den FPGA können jedoch nicht die analogen elektrischen Eigenschaften der Bauelemente einer solchen Einheit, etwa der Verstärkungsfaktor eines Transistors in Verstärkerschaltung oder der Widerstand eines Bauelements verändert werden. Die Möglichkeiten, Designs von gemischten mikroelektronischen Schaltungsanordnungen einzustellen, ist daher auf einige wenige Anwendungen beschränkt, die bei der Schaltungsanordnung im vorhinein zu berücksichtigen sind.

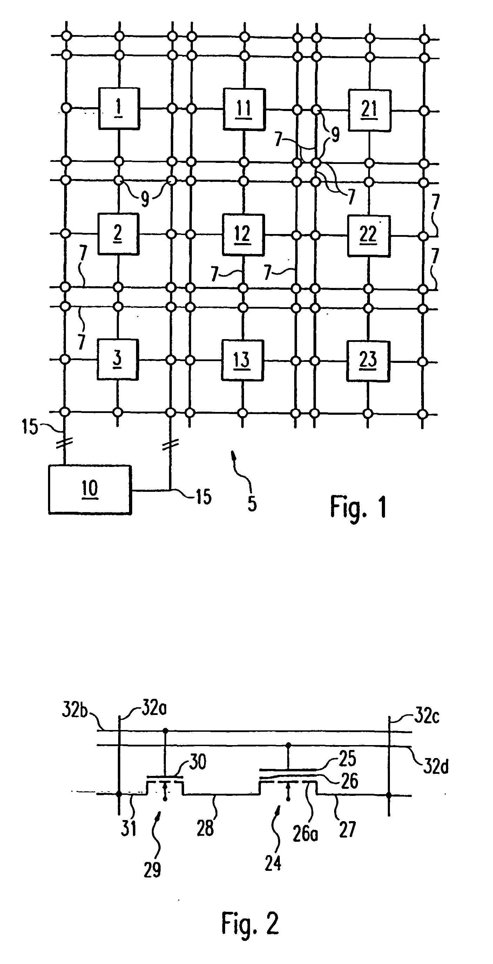

Die Druckschrift EP 0 978 843 A beschreibt einen Transistor mit einem Floating Gate, eine mehrstufige Speicherzelleneinrichtung und ein Verfahren zum Programmieren der Zellen und zum Stabilisieren der programmierten Ladung. In der Fig. 2 ist ein Programmierschaltkreis für die Speicherzellen dargestellt, wobei die Speicherzellen in Form einer Matrix aus mehrstufigen Flash-Speicherzellen angeordnet sind, die jeweils ein Floating Gate aufweisen. Der Programmierschaltkreis weist eine Anzahl von Pulsgeneratoren auf, von denen jeweils einer durch einen Schalter zuschaltbar ist. Ferner weist der Programmierschaltkreis eine Anzahl von logischen UND-Gattern und Zählern auf. Eine Anschluss-Seite der Speicherzellen wird durch einen Schalter über einen je nach Schalterstellung auswählbaren Widerstand mit dem Masseanschluss verbunden.

Aufgabe der vorliegenden Erfindung ist es, ein Verfahren und ein System der eingangs genannten Art anzugeben, die es ermöglichen, analoge elektrische Eigenschaften der Schaltungsanordnung kontinuierlich einzustellen, d.h. aus einem kontinuierlichen Wertebereich auswählen zu können. Eine weitere Aufgabe der vorliegenden Erfindung ist es, die Verwendung eines mikroelektronischen Schaltungselements anzugeben, mit dem sich das vorgenannte Ziel erreichen läßt.

Die Aufgaben werden durch ein Verfahren mit den Merkmalen des Anspruchs 1, durch ein System mit den Merkmalen des Anspruchs 5 und durch eine Verwendung mit den Merkmalen des Anspruchs 8 gelöst. Weiterbildungen sind Gegenstand der abhängigen Ansprüche.

Gemäß einem Grundgedanken der vorliegenden Erfindung wird in einem Konfigurationsschritt vor oder während des Betriebs der Schaltungsanordnung die analoge Einheit durch Zuführen und/oder Abführen elektrischer Ladung in einen Zustand versetzt, der analoge elektrische Eigenschaften der Einheit dauerhaft bestimmt, so daß die Schaltungsanordnung unter Ausnutzung dieser Eigenschaften betrieben werden kann. Dadurch kann der Ladungszustand der analogen Einheit, insbesondere der Ladungszustand eines während des Betriebes elektrisch isolierten Bereichs, auf einen Ladungswert eingestellt werden, der innerhalb eines kontinuierlichen Wertebereichs liegt. Hierdurch wird wiederum die elektrische Feldstärke festgelegt, die von dem in der Regel aufgeladenen Bereich ausgeht. In mikroelektronischen Bauelementen bedeutet dies eine Beeinflussung der elektrischen Eigenschaften benachbarter Bereiche, so daß die zu der analogen Einheit gehörenden benachbarten Bereiche bestimmte, von der Feldstärke abhängige Eigenschaften haben, unter deren Ausnutzung die Schaltungsanordnung betrieben werden kann.

Beispielsweise weist die analoge Einheit ein mikroelektronisches Schaltungselement mit einem Floating Gate auf. In dem Konfigurationsschritt wird das Floating Gate auf einen, innerhalb eines kontinuierlichen Wertebereichs liegenden beliebigen Ladungswert aufgeladen. Durch den Ladungszustand des Floating Gate wird dann beispielsweise die Schwellenspannung bestimmt, bei der überhaupt ein Stromfluß zwischen zwei zugeordneten Elektroden stattfinden kann, wenn eine elektrische Spannung an die Elektroden angelegt wird.

Vorzugsweise wird zumindest eine der analogen Eigenschaften der analogen Einheit, insbesondere eine Schwellenspannung eines Transistors mit einem Floating Gate, während und/oder nach dem Zuführen bzw. Abführen der elektrischen Ladung gemessen und gegebenenfalls korrigiert. Die Messung kann während des Konfigurationsschrittes oder danach erfolgen. In jedem Fall erlaubt dies, den eingestellten Zustand zu überprüfen und gegebenenfalls zu korrigieren.

Bei einer Weiterbildung weist die Schaltungsanordnung Mittel zum Verbinden und/oder Trennen von Schaltungselementen auf, beispielsweise Schaltelemente mit einem oder mehreren Schalttransistoren. Dies entspricht dem herkömmlichen Konzept, das bei FPGA angewendet wird. In Kombination mit der vorliegenden Erfindung ergeben sich daraus eine Vielzahl von Möglichkeiten eine Schaltungsanordnung mit analoger Einheit zu konfigurieren. Im Extremfall stehen einzelne Bauelemente zur Verfügung, deren analoge Eigenschaften gemäß der Erfindung eingestellt werden können, und sind ausreichend Schaltmittel und Leitungsverbindungen vorgesehen, um nahezu beliebige Schaltungen einstellen zu können. Der wesentliche Vorteil gegenüber herkömmlichen Konzepten besteht darin, daß nur eine begrenzte, überschaubare Anzahl von Schaltungselementen einer bestimmten Art bereitgestellt werden müssen, da ja die analogen Eigenschaften der Schaltungselemente eingestellt werden können.

Mit besonderem Vorteil kann das erfindungsgemäße Verfahren beim Design mikroelektronischer Schaltungsanordnungen eingesetzt werden. Die Erfindung ermöglicht es nämlich, bei einer konfigurierbaren mikroelektronischen Schaltungsanordnung analoge elektrische Eigenschaften reversibel einzustellen und das Schaltungsdesign zu testen. Bei erfolgreichem Test kann dann, etwa in Serienfertigung, eine weitere Schaltungsanordnung mit den gleichen, jedoch unveränderbaren analogen Eigenschaften hergestellt werden. Designfehler bei der weiteren Schaltungsanordnung können somit vermieden werden.

Als Beispiel für ein Bauelement, dessen analoge Eigenschaften in der beschriebenen Weise konfigurierbar sind, soll hier ein Schaltungselement mit einem Floating Gate, insbesondere ein FLOTOX(Floating Gate Tunneling Oxide)-Element genannt werden. Bei einem FLOTOX wird die Aufladung oder Entladung des Floating Gate unter Ausnutzung des Tunneleffekts bewirkt. Meist wird hierzu eine im Vergleich zu dem Betrieb des Bauelements ungewöhnlich große Spannung angelegt, so daß Ladungsträger mit einer großen Wahrscheinlichkeit durch die das Floating Gate umgebenden isolierenden Bereiche hindurchtunneln können. Die Erfindung ist jedoch nicht auf die Ausnutzung des Tunneleffekts beschränkt. Vielmehr können andere, aus dem Stand der Technik bekannte Methoden zum Ändern des Ladungszustandes eines Floating Gate angewandt werden.

Die Erfindung wird nun anhand von Ausführungsbeispielen näher beschrieben. Dabei wird Bezug auf die beigefügte Zeichnung genommen. Die Erfindung ist jedoch nicht auf diese Ausführungsbeispiele beschränkt. Die einzelnen Figuren der Zeichnungen zeigen:
- Fig. 1: eine Schaltungsanordnung und eine Einstelleinrichtung zum Einstellen analoger Eigenschaften der Schaltungsanordnung,
- Fig. 2: einen hinsichtlich seiner analogen Eigenschaften einstellbaren Transistor mit einem vorgeschalteten Schalttransistor,
- Fig. 3: die Schaltungsanordnung nach Fig. 1 in einem bestimmten Schaltungszustand und
- Fig. 4: ein Schaltbild, das dem in Fig. 3 dargestellten Schaltungszustand entspricht.

Fig. 1 zeigt eine Schaltungsanordnung 5 mit einer Mehrzahl analoger und digitaler Einheiten. Digitale Einheiten der Schaltungsanordnung 5 sind mit den Bezugszeichen 1, 2, 3 und 21, 22, 23 bezeichnet. Die digitalen Einheiten dienen der Verarbeitung binärer Information. An ihren Ein- und Ausgängen stehen daher während des Betriebes binäre Signale an. Analoge Einheiten der Schaltungsanordnung 5 sind mit den Bezugszeichen 11, 12, 13 bezeichnet. Die analogen Einheiten 11, 12, 13 können optional auch Schaltungselemente aufweisen, die digitale Information verarbeiten können.

Die digitalen und analogen Einheiten 1 bis 3, 11 bis 13 und 21 bis 23 sind von einem Netz elektrischer Leitungen umgeben, die beispielhaft mit dem Bezugszeichen 7 bezeichnet sind. Das Netz der elektrischen Leitungen 7 weist eine Vielzahl von Knoten auf, die beispielhaft mit dem Bezugszeichen 9 bezeichnet sind. An den Knoten 9 befinden sich nicht näher dargestellte Schaltelemente, die es erlauben, jede der vier an dem Knoten ansetzenden elektrischen Leitungen 7 entweder elektrisch miteinander zu verbinden oder elektrisch gegeneinander zu isolieren. Die Schaltelemente sind über nicht dargestellte Mittel ansteuerbar, so daß der Schaltzustand von außen einstellbar ist. Ausführungsformen für derartige Schaltelemente sind beispielsweise US 5,563,536 entnehmbar.

Mit der Schaltungsanordnung 5 ist eine Einstelleinrichtung 10 elektrisch verbunden. Über Anschlußleitungen 15 kann die Einstelleinrichtung 10 mit dem Netz der elektrischen Leitungen 7 verbunden werden. Weiterhin kann durch entsprechende Ansteuerung der Schaltelemente an den Knoten 9 die Einstelleinrichtung 10 mit jeder der Einheiten 1 bis 3, 11 bis 13 und 21 bis 23 verbunden werden. Vorzugsweise hat die Einstelleinrichtung 10 nicht nur die zwei schematisch dargestellten Anschlußleitungen 15, sondern eine Vielzahl von Anschlußleitungen, die es erlauben, jede mögliche Einstellung von analogen und digitalen Eigenschaften vorzunehmen. Insbesondere können mehrere Einstellvorgänge zeitparallel vorgenommen werden.

Fig. 2 zeigt einen Transistor 24, der ein Steuergate und ein Floating Gate 26 aufweist. Über eine Sourceleitung 27 und eine Drainleitung 28 sind Source und Drain des Transistors 24 elektrisch angeschlossen. Die Drainleitung 28 verbindet Drain des Transistors 24 mit Source eines Schalttransistors 29, über den der Transistor 24 elektrisch mit einer Anschlußleitung 32a verbindbar ist. Source des Transistors 24 ist permanent elektrisch mit einer Anschlußleitung 32c verbunden. Das Steuergate 25 ist mit einer Anschlußleitung 32d verbunden. Weiterhin zeigt Fig. 2 noch eine Anschlußleitung 32b, die mit einem Steuergate 30 des Schalttransistors 29 verbunden ist. Die elektrische Verbindung zwischen Drain des Schalttransistors 29 und der Anschlußleitung 32a wird durch eine Drainleitung 31 hergestellt.

Die Kombination der Transistoren 24, 29 gleicht dem Aufbau einer digitalen EEPROM (Electrically Erasable Programmable Read Only Memory)-Zelle, die bekanntermaßen zur Speicherung digitaler Information verwendet wird. Die Darstellung in Fig. 2 ist schematisch zu verstehen. Der Schalttransistor 29 und der Transistor 24 müssen nicht, wie Fig. 2 entnommen werden könnte, räumlich voneinander getrennt sein. Vielmehr sind moderne, kompakte Designs von EEPROM-Zellen bekannt mit einer Mehrzahl teilweise übereinander liegender Gates, so daß zum Aufladen und Entladen des Floating Gate nur geringe Ströme erforderlich sind. Ein Beispiel für eine solche EEPROM-Zelle ist in US 5,847,996 beschrieben. Die Erfindung ist nicht auf Transistoren beschränkt, die in EEPROM-Zellen vorkommen. Vielmehr können beispielsweise auch Halbleiterbauelemente mit Floating Gate, jedoch mehr als zwei elektrisch von außen zugänglichen Halbleiterbereichen verwendet werden.

In ähnlicher Weise wie dies aus dem Stand der Technik bekannt ist, wird der Transistor 24 (Fig. 2) hinsichtlich seiner analogen elektrischen Eigenschaften konfiguriert. Beispielsweise wird zwischen das Steuergate 25 und Drain eine elektrische Spannung von 12 V angelegt, während Source des Transistors 24 frei floaten kann, d.h. die Anschlußleitung 32c von außen nicht angeschlossen ist.

Bei einer Ausführungsform befindet sich in mindestens einer der analogen Einheiten 11, 12, 13 nach Fig. 1 die in Fig. 2 dargestellte Anordnung. Die Einstellung des Ladungszustandes des Floating Gate 26 kann daher durch die Einstelleinrichtung 10 vorgenommen werden. Insbesondere mißt die Einstelleinrichtung 10 den über die Drainleitung 28 in den Transistor 24 hineinfließenden bzw. den aus ihm herausfließenden elektrischen Strom. Hieraus kann auf den Ladungszustand des Floating Gate 26 geschlossen werden, wenn der Anfangszustand des Floating Gate 26 bekannt ist. Es bietet sich insbesondere an, vor Beginn des Einstellvorganges zunächst das Floating Gate 26 so weit zu entladen, wie dies möglich ist.

Durch das Aufladen des Floating Gate 26 werden nicht nur statische elektrische Eigenschaften des Transistors 24, wie Schwellenspannung und statisches Verstärkungsverhalten beeinflußt, sondern auch dynamische Eigenschaften, die beispielsweise für Treiber maßgeblich sind, welche in vielfacher Weise in mikroelektronischen Schaltungsanordnungen zur Anwendung kommen. Von einem Treiber wird gefordert, ein Spannungssignal an seinem Ausgang innerhalb einer bestimmten Zeitspanne um einen bestimmten Betrag zu erhöhen und/oder zu erniedrigen. Die Fähigkeit eines Treibers, die Spannungsänderung in einer bestimmten Zeit, meist innerhalb weniger Nanosekunden, zu vollführen, nennt man Stärke des Treibers. Die Stärke des Treibers ist eine in hohem Grade dynamische analoge Eigenschaft, die durch Einstellen des Ladungszustands einer Floating Gate eingestellt werden kann.

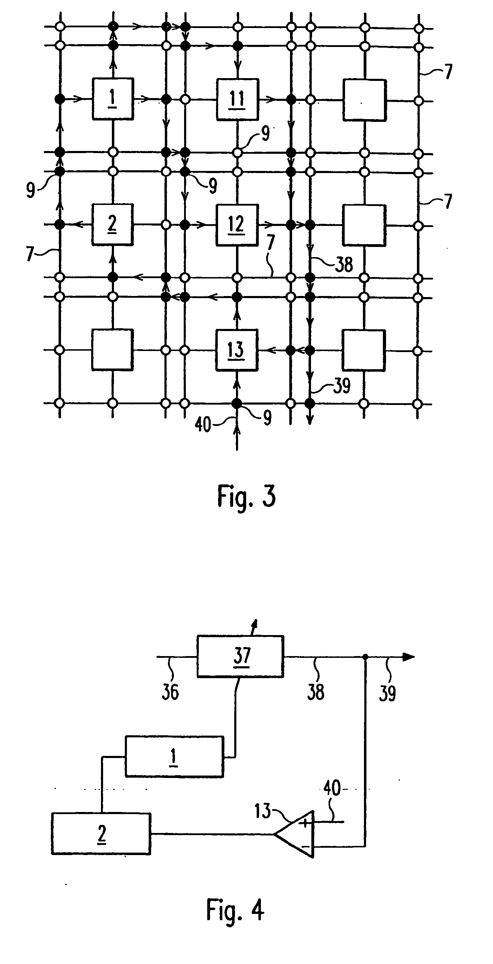

Beispielsweise weisen die analogen Einheiten 11, 12 einer Schaltungsanordnung nach Fig. 1 jeweils zumindest einen Transistor der Art des Transistors 24 gemäß Fig. 2 auf. Ein Beispiel für eine Schaltung, die aus der Schaltungsanordnung 5 konfigurierbar ist, zeigen Fig. 3 und Fig. 4.

Die in Fig. 3 dunkel ausgefüllt dargestellten Knoten 9 des Netzes von elektrischen Leitungen 7 stellen elektrisch leitende Verbindungen zwischen den an ihnen angeschlossenen elektrischen Leitungen 7 dar. Dagegen stellen die nicht dunkel ausgefüllten Knoten 9 eine Isolierung der elektrischen Leitungen 7 dar.

Der in Fig. 3 dargestellte Schaltungszustand entspricht dem in Fig. 4. Ein Treiber 37 (Fig. 4) weist die analogen Einheiten 11, 12 mit jeweils einem hinsichtlich seiner analogen Eigenschaften einstellbaren Transistor 24 auf. Die Stärke des einstellbaren Transistors in der analogen Einheit 11 und die Stärke des Transistors in der analogen Einheit 12 werden vorab unter Verwendung der Einstelleinrichtung 10 so eingestellt, daß die Stärke des einen Transistors halb so groß ist wie die Stärke des anderen Transistors. Dies ermöglicht eine Regelschaltung zur Regelung der Stärke des Treibers 37, die es erlaubt, die Treiberstärke in äquidistanten Stufen unter Verwendung einer binären Steuerung einzustellen. Die Funktionsweise wird im folgenden beschrieben.

Wie aus Fig. 3 ersichtlich ist, sind die beiden analogen Einheiten 11, 12 und damit die beiden Transistoren parallel geschaltet. An einem Treiberausgang 38 ist somit das Treiberausgangssignal abgreifbar, welches aufgrund der Gesamtstärke des Treibers 37 erzeugt wird. Die Einzelstärken der beiden Transistoren addieren sich zu der Gesamtstärke des Treibers 37. Die beschriebene Schaltung erlaubt es, die beiden Transistoren einzeln durch binäre Signale freizugeben oder zu sperren. Da die Stärke des einen Transistors halb so groß ist wie die Stärke des anderen Transistors, ergeben sich drei Zustände für die Treiberstärke, falls der Treiber überhaupt aktiviert ist. Die geringste Treiberstärke entspricht der Stärke des schwächeren Transistors. Die größte Treiberstärke entspricht dem Zustand, wenn beide Transistoren aktiviert sind. Diese drei Stärkenzustände unterscheiden sich von einem benachbarten Stärkenzustand jeweils um einen Stärkenwert, der der Stärke des schwächeren Transistors entspricht.

Bei dieser Beschreibung wurden der Einfachheit halber nur zwei parallel geschaltete Transistoren erwähnt. Im allgemeine kann ein derartiger, aus parallelen Transistoren zusammengesetzter Treiber mehr als zwei Teiltreiber haben, die in der gleichen Weise hinsichtlich ihrer Stärke abgestuft sind, so daß der nächst stärkere Treiber jeweils die doppelte Stärke hat. Beispielsweise kann mit fünf derartigen Teiltreibern die Treiberstärke auf 31 äquidistante Stärkenwerte eingestellt werden.

Die Funktionsweise der Treiberstärkenregelung ist wie folgt: Das am Treiberausgang 38 anliegende Treiberausgangssignal wird dem invertierenden Eingang eines Komparators 13 zugeführt. Der Komparator 13 entspricht der analogen Einheit 13 der Schaltungsanordnung 5. Der nicht invertierende Eingang des Komparators 13 ist über einen der Knoten 9 mit einem Referenzspannungsanschluß 40 verbunden, an dem eine Referenzspannung anliegt. Diese Referenzspannung ist ein Maß für die gewünschte Treiberstärke. Abhängig davon, ob die gewünschte Treiberstärke tatsächlich erreicht, unterschritten oder überschritten wird, ist das zeitliche Verhalten des von dem Komparator 13 an die digitale Einheit 2 ausgegebene Ausgangssignal verschieden. Durch vorherige Konfiguration der digitalen Einheiten 1, 2 wurden diese in die Lage versetzt, das Ausgangssignal des Komparators 13 auszuwerten und ein dementsprechendes Stellsignal an die analogen Einheiten 11, 12 auszugeben. Hierdurch wird eine bestimmte Kombination der Transistoren freigegeben, so daß die Stärke des Treibers 37 eingestellt wird. Bei Eingang des nächsten Triggersignals am Treibereingang 36 (Fig. 4) zeigt der Treiber 37 dann das der eingestellten Treiberstärke entsprechende dynamische Verhalten.

Ein weiteres Ausführungsbeispiel für eine Schaltungsanordnung, die mit Vorteil hinsichtlich ihrer analogen Eigenschaften konfigurierbar ist, ist eine Spannungsverstärkungsschaltung. Hierbei können ein oder mehrere Verstärkungsfaktoren und/oder Offsetwerte der Verstärkungsschaltung eingestellt werden. Es kann somit ein universell einsetzbares Verstärkungsmodul hergestellt werden, daß nur noch für den jeweiligen Einsatzzweck zu konfigurieren ist. Insbesondere ist auf einem gemeinsamen Chip auch eine Einstelleinrichtung vorgesehen, die die Konfiguration ausführt und die durch Steuerbefehle von außen ansteuerbar ist. Durch die Steuerbefehle, etwa eines Steuerungsrechners, kann dann die jeweils gewünschte Konfiguration erreicht werden.

Anwendungen solcher und anderer Schaltungsanordnungen liegen z.B. auf dem Gebiet der Messung physikalischer Größen, wie Temperatur oder Feuchtigkeitsgehalt von Luft. Hierbei kann eine analoge Meßfunktion von einer für die Anwendung konfigurierten analogen Einheit übernommen werden. Gleichzeitig kann eine digitale Zählerfunktion (etwa zum Integrieren einer gemessenen Wärmeleistung über die Zeit) durch eine digitale Einheit der selben Schaltungsanordnung übernommen werden.

Eine andere mögliche Anwendung liegt auf dem Gebiet digitaler oder analoger Filterschaltungen, insbesondere für Hifi-Akkustikgeräte, Hörgeräte, Graphic-Equalizer, digitale Medien, etwa Mobiltelefone, digitales Fernsehen und Radio. Jeweils läßt sich insbesondere eine Grenzfrequenz der Filterschaltung durch die erfindungsgemäße Einstellung analoger elektrischer Eigenschaften variabel einstellen.

Noch eine weitere Anwendung betrifft die Wandlung analoger Signale in digitale Signale und/oder umgekehrt. Beispielsweise können hier bei für die Wandlung maßgeblicher Schwellwerte von Signalstärken durch die Konfiguration variabel eingestellt werden. Dies erlaubt es dem Anwender die Schwellwerte später zu verändern. Alternativ können die Schwellwerte vor Auslieferung an den Anwender vorkonfiguriert werden. Ein weiteres Anwendungsfeld bei der Wandlung von Signalen besteht dort, wo ein Linearisieren analoger Signale gefordert wird. Hierbei läßt sich durch Konfiguration der analogen elektrischen Eigenschaften eine gleichmäßige Empfindlichkeit über den gesamten Analogbereich herstellen. Insbesondere können an sich bekannte Speicherzellen zur Speicherung digitaler Information für die Speicherung von analogen Werten oder für die Speicherung von mehr als zwei diskreten Werten eingesetzt werden. Ein bestimmter Ladungszustand einer solchen Speicherzelle wird also nicht entweder als "Null" oder "Eins" interpretiert, sondern als einer von mehr als zwei möglichen Werten interpretiert. Beispielsweise können so beliebige Fitparameter zur Verwendung bei der A/D-Wandlung oder bei der D/A-Wandlung gespeichert werden.

Ein weiteres Anwendungsgebiet betrifft analoge Rechenwerke. Analoges Rechnen hat gegenüber dem digitalen Rechnen den Vorteil, daß nicht erst eine Digitalisierung vorliegender analoger Werte oder Zahlen stattfinden muß. Das analoge Rechnen kann daher in Echtzeit oder zumindest nahezu in Echtzeit ausgeführt werden. Beispielsweise kann die zuvor beschriebene Verfahrensweise der Speicherung eines analogen, oder aufgrund einer feinen Diskretisierung quasi-analogen Wertes genutzt werden. Ein Ausführungsbeispiel hierfür betrifft die Berechnung eines Temperaturwertes aus dem Spannungssignal eines Thermoelements. Wenn der Temperaturwert an einer beliebigen Stelle innerhalb eines großen Temperatur-Meßbereichs liegen kann, wird die mathematische Funktion, durch die sich der gemessene Spannungswert in einen Temperaturwert umrechnen läßt, durch ein Polynom höheren Grades ausgedrückt, beispielsweise durch ein Polynom vierten Grades. Es sind somit fünf Konstanten der mathematischen Funktion zu berücksichtigen. Diese fünf Konstanten werden jeweils in einer Speicherzelle abgelegt, so daß ein analoges Rechenwerk unmittelbar die Werte der Konstanten auslesen und verarbeiten kann. Gegenüber digitalen Rechenwerken kann daher Rechenzeit gespart werden. Dies ist insbesondere dann von Vorteil, wenn - wie bei der Messung von Temperaturwerten während der Fertigung von Halbleiterbauelementen - in kurzen zeitlichen Abständen jeweils eine Vielzahl von Temperaturwerten zu berechnen sind. Als Folge der schnelleren Berechnung ist ein schnelleres Reagieren auf Temperaturschwankungen möglich. Im Ergebnis läßt sich also die Totzeit einer Temperaturreglung deutlich verkürzen. Dies führt letztendlich zu einer größeren zeitlichen Konstanz der Temperatur und damit unter anderem zu geringerem Ausschuß bei der Halbleiterfertigung.

Bei dem analogen Rechenwerk wird insbesondere zur Verarbeitung der analogen gespeicherten Werte und der Meßwerte eine analoge Komparatorschaltung eingesetzt. Dies ermöglicht die Entscheidung, ob ein Meßwert und/oder ein daraus berechneter Zwischenwert größer oder kleiner als ein Referenzwert ist. Das analoge Rechenergebnis kann auf diese Weise in ein korrespondierendes binäres Signal umgewandelt werden, welches eine Weiterverarbeitung in klassischer, digitaler Weise erlaubt. Die Ausgangssignale von Komparatorschaltungen können jedoch auch zur weiteren analogen Bearbeitung des Signals bzw. des Rechenergebnisses eingesetzt werden.

Diese Anwendung ist nicht auf die Messung von Temperaturwerten beschränkt. Vielmehr können auch Werte von Drucksensoren, Beschleunigungssensoren, die insbesondere bei Airbags Verwendung finden, Gassensoren, insbesondere zur Überwachung von Auspuffgasen, und von anderen Meßsensoren auf diese Weise ausgewertet werden. Weitere Anwendungsfelder liegen auf den Gebieten der Biometrik, beispielsweise der Erkennung bestimmter Strukturen der menschlichen Iris, der Bilderkennung allgemein und auf dem Gebiet des fuzzy-logischen Rechnens.

Durch die Erfindung lassen sich mit geringem schaltungstechnischen Aufwand Schaltungsanordnungen betreiben, die in unterschiedlichster Weise konfiguriert werden können. Damit wird es insbesondere möglich, Designs von Schaltungsanordnungen mit gemischten digitalen und analogen Funktionen besser testen zu können, bevor eine Serienfertigung mikroelektronischer Schaltungen mit bestimmten Eigenschaften beginnt.

Andererseits können durch ein "universelles" Design innerhalb einer Goßserie verschiedene Anwendungen individuell programmiert werden.

## Patentansprüche

1. Verfahren zum Einstellen der elektrischen Eigenschaften einer mikroelektronischen Schaltungsanordnung (5), wobei
- die Schaltungsanordnung (5) eine Anzahl von analogen und digitalen elektronischen Einheiten (1-3, 11-13, 21-23), eine Anzahl von elektrischen Leitungen (7) und eine Anzahl von Schaltelementen an Knotenpunkten (9) der elektrischen Leitungen (7) derart aufweist, dass die analogen und digitalen Einheiten (1-3, 11-13, 21-23) elektrisch miteinander verbindbar oder voneinander trennbar sind,
- durch elektrisches Verbinden und/oder Trennen von analogen und digitalen elektronischen Einheiten (1-3, 11-13, 21-23) mittels der Schaltelemente an den Knotenpunkten (9) die elektrischen Eigenschaften der Schaltungsanordnung (5) eingestellt werden, und
- in einem Konfigurationsschritt vor oder während des Betriebs der Schaltungsanordnung (5) eine analoge Einheit (11, 12) durch Zuführen und/oder Abführen elektrischer Ladung in einen Zustand versetzt wird, der analoge elektrische Eigenschaften der Einheit (11, 12) dauerhaft bestimmt, so daß die Schaltungsanordnung (5) unter Ausnutzung dieser Eigenschaften betrieben werden kann.

2. Verfahren nach Anspruch 1,
**dadurch gekennzeichnet, daß**
die analoge Einheit (11, 12) ein mikroelektronisches Schaltungselement (24) mit einem Floating Gate (26) aufweist, und daß in dem Konfigurationsschritt das Floating Gate (26) auf einen beliebig einstellbaren innerhalb eines kontinuierlichen Wertebereichs liegenden Ladungswert aufgeladen wird.

3. Verfahren nach Anspruch 1 oder 2,
**dadurch gekennzeichnet, daß**
zumindest eine der analogen Eigenschaften, insbesondere eine Schwellenspannung eines Transistors 24 mit einem Floating Gate (26), während und/oder nach dem Zuführen bzw. Abführen der elektrischen Ladung gemessen und gegebenenfalls korrigiert wird.

4. Verfahren nach einem der vorhergehenden Ansprüche,
**dadurch gekennzeichnet, daß**
das Einstellen der analogen elektrischen Eigenschaften reversibel ist und daß eine weitere Schaltungsanordnung mit den gleichen, jedoch unveränderbaren analogen Eigenschaften hergestellt wird.

5. System mit
- einer mikroelektronischen Schaltungsanordnung (5), die eine Anzahl von analogen und digitalen elektronischen Einheiten (1-3, 11-13, 21-23), eine Anzahl von elektrischen Leitungen (7) und eine Anzahl von Schaltelementen an Knotenpunkten (9) der elektrischen Leitungen (7) derart aufweist, dass die analogen und digitalen Einheiten (1-3, 11-13, 21-23) elektrisch miteinander verbindbar oder voneinander trennbar sind,
- in der Anzahl von analogen und digitalen elektronischen Einheiten (1-3, 11-13, 21-23) eine analoge Einheit (11, 12) enthalten ist, welche einen elektrisch isolierten Bereich (26) aufweist, dessen elektrischer Ladungszustand analoge elektrische Eigenschaften der Einheit (11, 12) bestimmt, und
- einer Einstelleinrichtung (10) zum Einstellen des Ladungszustandes auf einen innerhalb eines kontinuierlichen Wertebereichs liegenden frei wählbaren Ladungswert.

6. System nach Anspruch 5,
**gekennzeichnet durch**
Mittel (10) zum Messen des Ladungszustandes und/oder zumindest einer der daraus resultierenden analogen Eigenschaften.

7. System nach Anspruch 5 oder 6,
**gekennzeichnet durch**
eine Einrichtung (1, 2, 3) zum Verarbeiten digitaler Information, die mit der analogen elektronischen Einheit (11, 12) elektrisch verbunden oder verbindbar ist.

## Claims

1. Method of setting the electrical characteristics of a microelectronic circuit arrangement (5), wherein
- the circuit arrangement (5) has a number of analogue and digital electronic units (1-3, 11-13, 21-23), a number of electrical lines (7) and a number of switching elements at nodes (9) on the electrical lines (7) such that the analogue and digital units (1-3, 11-13, 21-23) can be electrically connected to or isolated from one another,
- the electrical characterisitics of the circuit arrangement (5) are set by electrically connecting and/or isolating analogue and digital electronic units (1-3, 11-13, 21-23) using the switching elements at the nodes (9), and
- in a configuration step before or during the operation of the circuit arrangement (5), by means of feeding and/or extracting electrical charge, the analogue unit (11, 12) is put into a state which permanently determines analogue electrical characteristics of the unit (11, 12), so that the circuit arrangement (5) can be operated using these characteristics.

2. Method according to Claim 1, **characterized in that** the analogue unit (11, 12) has a microelectronic circuit element (24) with a floating gate (26), and **in that**, in the configuration step, the floating gate (26) is charged up to a charge value which can be set as desired and lies within a continuous value range.

3. Method according to Claim 1 or 2, **characterized in that** at least one of the analogue characteristics, in particular a threshold voltage of a transistor 24 with a floating gate (26), is measured and, if necessary, corrected during and/or after the feeding or extraction of the electrical charge.

4. Method according to one of claims 1 to 4,
**characterized in that** the setting of the analogue electrical characteristics is reversible, and **in that** a further circuit arrangement having the same, but unchangeable, analogue characteristics is produced.

5. System having
- a microelectronic circuit arrangement (5) which has a number of analogue and digital electronic units (1-3, 11-13, 21-23), a number of electrical lines (7) and a number of switching elements at nodes (9) on the electrical lines (7) such that the analogue and digital units (1-3, 11-13, 21-23) can be electrically connected to or isolated from one another,
- the number of analogue and digital electronic units (1-3, 11-13, 21-23) contains an analogue unit (11, 12) which has an electrically insulated region (26) whose electrical charge state determines analogue electrical characteristics of the unit (11, 12), and
- a setting device (10) for setting the charge state to a freely selectable charge value lying within a continuous value range.

6. System according to Claim 5, **characterized by** means (10) for measuring the charge state and/or at least one of the analogue characteristics resulting from this.

7. System according to Claim 5 or 6, **characterized by** a device (1, 2, 3) for processing digital information, which is or can be connected electrically to the analogue electronic unit (11, 12) .

## Revendications

1. Procédé de réglage des propriétés électriques d'un circuit (5) microélectronique, dans lequel
- le circuit (5) a un certain nombre d'unités (1 à 3, 11 à 13, 21 à 23) électroniques, analogiques et numériques, un certain nombre de lignes (7) électriques et un certain nombre d'éléments de commutation en des points (9) nodaux des lignes (7) électriques, de sorte que les unités (1 à 3, 11 à 13, 21 à 23) analogiques et numériques peuvent être reliées entre elles ou peuvent être séparées les unes des autres du point de vue électrique,
- on règle les propriétés électriques du circuit (5) en reliant et/ou en séparant électriquement les unités (1 à 3, 11 à 13, 21 à 23) électroniques, analogiques et numériques, au moyen des éléments de commutation sur les points (9) nodaux, et
- dans un stade de configuration avant ou pendant le fonctionnement du circuit (5), on met une unité (11, 12) analogique, par apport et/ou évacuation d'une charge électrique, dans un état qui détermine de manière permanente des propriétés électriques analogiques de l'unité (11, 12), de sorte que le circuit (5) peut fonctionner en utilisant ces propriétés.

2. Procédé suivant la revendication 1,
**caractérisé en ce que**
l'unité (11, 12) analogique a un élément (24) de circuit microélectronique ayant une grille (26) flottante et **en ce que**, dans le stade de configuration, on charge la grille (26) flottante jusqu'à une valeur de charge réglable à volonté et se trouvant à l'intérieur d'une plage de valeurs continues.

3. Procédé suivant la revendication 1 ou 2,
**caractérisé en ce que**
on mesure et, le cas échéant, corrige au moins l'une des propriétés analogiques, notamment une tension de seuil d'un transistor (24) ayant une grille (26) flottante pendant et/ou après l'apport ou l'évacuation de la charge électrique.

4. Procédé suivant l'une des revendications précédentes,
**caractérisé en ce que**
le réglage des propriétés électriques analogiques est réversible et **en ce que** l'on produit un autre circuit ayant les mêmes propriétés analogiques mais qui ne peuvent pas être modifiées.

5. Système comprenant
- un montage (5) microélectronique qui a un certain nombre d'unités (1 à 3, 11 à 13, 21 à 23) électroniques, analogiques et numériques, un certain nombre de lignes (7) électriques et un certain nombre d'éléments de commutation en des points (9) nodaux des lignes (7) électriques, de sorte que les unités (1 à 3, 11 à 13, 21 à 23) analogiques et numériques peuvent être reliées entre elles ou peuvent être séparées les unes des autres du point de vue électrique,
- parmi le nombre d'unités (1 à 3, 11 à 13, 21 à 23) électroniques, analogiques et numériques, il y a une unité (11, 12) analogique qui a une partie (26) isolée électriquement, dont l'état de charge électrique détermine les propriétés électriques analogiques de l'unité (11, 12), et
- un dispositif (10) de réglage de l'état de charge jusqu'à une valeur de charge pouvant être choisie à volonté et se trouvant à l'intérieur d'une plage de valeurs continues.

6. Système suivant la revendication 5,
**caractérisé par**
un moyen (10) de mesure de l'état de charge et/ou d'une propriété analogique en résultant.

7. Système suivant la revendication 5 ou 6,
**caractérisé par**
un dispositif (1, 2, 3) de traitement d'une information numérique, qui est relié ou qui peut être relié électriquement à l'unité (11, 12) électronique analogique.
